Europäisches Patentamt

European Patent Office

Office européen des brevets

(19)

(11) **EP 1 298 444 A1**

(12) **EUROPÄISCHE PATENTANMELDUNG**

(43) Veröffentlichungstag:
   **02.04.2003   Patentblatt 2003/14**

(51) Int Cl.⁷: $G01R\ 31/36$

(21) Anmeldenummer: **01123434.1**

(22) Anmeldetag: **28.09.2001**

| | |
|---|---|
| (84) Benannte Vertragsstaaten:<br>**AT BE CH CY DE DK ES FI FR GB GR IE IT LI LU MC NL PT SE TR**<br>Benannte Erstreckungsstaaten:<br>**AL LT LV MK RO SI** | (72) Erfinder:<br>• **Nann, Eberhard, Dr.**<br>  **59494 Soest (DE)**<br>• **Kuper, Christian, Dr.**<br>  **59929 Brilon (DE)** |
| (71) Anmelder: **Johnson Controls Batterien GmbH & Co. KG**<br>**59929 Brilon (DE)** | (74) Vertreter: **Stenger, Watzke & Ring Patentanwälte**<br>**Kaiser-Friedrich-Ring 70**<br>**40547 Düsseldorf (DE)** |

(54) **Verfahren zur Ermittlung von Zustandsgrössen eines Akkumulators**

(57)   Der Erfindung liegt die Aufgabe zugrunde, Zustandsgrößen eines Akkumulators, insbesondere einen Lade- und Alterungszustand, zu ermitteln, ohne daß der Akkumulator von dem mit ihm verbundenen elektrischen System zu trennen ist oder vorgegebene Betriebsmodi erzeugt werden müssen.

Dazu wird zumindest die Akkumulatorspannung (14), der Akkumulatorstrom (16) und die Akkumulatortemperatur (18) während eines bestimmungsgemäßen Betriebs des Akkumulators (12) an einem mit dem Akkumulator (12) elektrisch verbundenen elektrischen System (20) gemessen werden, und wobei durch das elektrische System (20) eine von mehreren wechselbaren Betriebsphasen (22,24,26,28,30,32) eingenommen wird, und eine Rechenvorschrift zur Berechnung der jeweils aus den Meßwerten zu ermittelnden Zustandsgröße (34,36,94) in Abhängigkeit der aktuellen Betriebsphase (22,24,26,28,30,32) ausgewählt, die jeweilige Zustandsgröße (34,36,94) berechnet und die in einer vorherigen Betriebsphase (22,24,26,28,30,32) entsprechend ermittelte Zustandsgröße (34,36,94) aktualisiert wird. Dabei kann das elektrische System zum Beispiel durch die elektrische Anlage eines Kraftfahrzeugs oder auch durch eine unterbrechungsfreie Energieversorgung einer Signalanlage oder dergleichen gebildet sein.

Ferner werden eine Vorrichtung (40) zur Durchführung des erfindungsgemäßen Verfahrens sowie ein Akkumulator (12) mit einem integrierten Temperatursensor (76) vorgeschlagen.

Aus den Zustandsgrößen (34,36,94) werden spezifische Informationen generiert, die ein übergeordnetes Managementsystem verarbeiten kann.

| | | | | | |
|---|---|---|---|---|---|
| Messen U | | | | | —14 |
| Messen I | | | | | —16 |
| Messen T | | | | | —18 |
| welche Betriebsphase ? | | | | | |
| 22 | 24 | 26 | 28 | 30 | 32 |
| | | | | | ←—58 |
| Bereitstellen der Zustandsgrößen -10- eines neuwertigen Akumulators | | | | | |
| Ermitteln der Zustandsgrößen | | | | | —62 |
| Aktualisieren der Zustandsgrößen | | | | | —66 |
| Speichern der aktuell ermittelten Zustandsgrößen | | | | | —60 |

**Beschreibung**

Die vorliegende Erfindung betrifft ein Verfahren zur Ermittlung von Zustandsgrößen eines Akkumulators, insbesondere eines Lade- und/oder Alterungszustands.

Im Stand der Technik sind Verfahren bekannt, mit denen ein Lade- und ein Alterungszustand eines Akkumulators ermittelt werden können, um beispielsweise eine Entscheidung hinsichtlich eines Ersatzes des Akkumulators zu treffen. Ferner ist bekannt, bei einem Bleiakkumulator für ein Kraftfahrzeug die Säurewichte zu messen, die vom Ladezustand des Akkumulators abhängig ist, um dessen Ladezustand zu ermitteln. Gerade bei wartungsfreien Akkumulatoren jedoch ist dieses Verfahren nicht anwendbar.

Darüber hinaus wird der Ladezustand eines Akkumulators durch Messen der Klemmenspannung ermittelt, wobei die gemessene Klemmenspannung nur dann ein Maß für den Ladungszustand darstellt, wenn sich eine aussagekräftige sogenannte Ruhespannung eingestellt hat. Dieser Zustand kann zum Beispiel bei einer Starterbatterie eines Kraftfahrzeugs, die zuvor geladen wurde, erst nach etwa zehn Stunden erreicht werden. Ansonsten müßte die Batterie ausgebaut werden, da die Batterie mit einem kleinen Strom (mA) entladen wird.

Um möglichst schnell zu einem Prüfergebnis zu kommen, schlägt zum Beispiel die EP 0 447 928 A1 vor, den zu messenden Akkumulator von dem mit ihm verbundenen elektrischen System abzuklemmen und an ein entsprechendes Prüfgerät anzuschließen. Das Prüfgerät führt gemäß einem vorgegebenen Ablauf drei Entladeschritte durch, wobei die Reaktion des Akkumulators gemessen und mit Werten eines neuwertigen geladenen Akkumulators verglichen wird. Aus der Abweichung wird mit Hilfe des gemessenen Ladezustands der Alterungszustand ermittelt.

Daneben offenbart beispielsweise die US 5 281 919 eine Vorrichtung für eine Anordnung im Kraftfahrzeug zur Bestimmung von Akkumulatorparametern wie Ladezustand, Kaltstartfähigkeit, usw. Dazu ist jedoch eine von einem Mikroprozessor analog steuerbare Lichtmaschine erforderlich, mit welcher vorgebbare Betriebszustände einstellbar sind, wobei aus der Reaktion des Akkumulators die gewünschten Informationen über dessen Zustand gewonnen werden. Darüber hinaus lehrt diese Druckschrift ein Abschalten des Akkumulators über entsprechende Leistungsschalter vor jedem Prüfzyklus, um die Ruhespannung zu ermitteln.

Grundsätzlich wird als nachteilig empfunden, daß der Akkumulator für eine Prüfung von dem mit ihm verbundenen elektrischen System abgeklemmt werden muß, sei es, um ihn an eine Prüfvorrichtung anzuklemmen oder um vor dem Start eines Prüfmodus einen definierten Zustand zu erzeugen. Darüber hinaus vermögen die bekannten Verfahren und Vorrichtungen keine kontinuierliche Aussage über einen hinreichend aktuellen Zustand des Akkumulators zu treffen.

Der Erfindung liegt die **Aufgabe** zugrunde, Zustandsgrößen eines Akkumulators, insbesondere einen Lade- und Alterungszustand, zu ermitteln, ohne daß der Akkumulator von dem mit ihm verbundenen elektrischen System zu trennen ist.

Zur **Lösung** der Aufgabe wird ein Verfahren zur Ermittlung von Zustandsgrößen eines Akkumulators, insbesondere eines Lade- und/oder Alterungszustands, vorgeschlagen, wobei zumindest die Akkumulatorspannung, der Akkumulatorstrom und die Akkumulatortemperatur während eines bestimmungsgemäßen Betriebs des Akkumulators an einem mit dem Akkumulator elektrisch verbundenen elektrischen System gemessen werden, und wobei durch das elektrische System eine von mehreren wechselbaren Betriebsphasen eingenommen wird, und eine Rechenvorschrift zur Berechnung der jeweils aus den Meßwerten zu ermittelnden Zustandsgröße in Abhängigkeit der aktuellen Betriebsphase ausgewählt, die jeweilige Zustandsgröße berechnet und die in einer vorherigen Betriebsphase entsprechend ermittelte Zustandsgröße aktualisiert wird. Dabei kann das elektrische System zum Beispiel durch die elektrische Anlage eines Kraftfahrzeugs oder auch durch eine unterbrechungsfreie Energieversorgung einer Signalanlage oder dergleichen gebildet sein. Die Messungen erfolgen kontinuierlich während der verschiedenen Betriebsphasen. Eine Rechenvorschrift zur Berechnung der jeweils aus den Meßwerten zu ermittelnden Zustandsgröße wird in Abhängigkeit der aktuellen Betriebsphase ausgewählt. Die jeweilige Zustandsgröße wird durch Vergleich mit einer hinterlegten Datenbank berechnet.

Hierdurch kann vorteilhaft erreicht werden, daß gemäß einer aktuellen Betriebsphase des elektrischen Systems eine Rechenvorschrift zur Ermittlung der jeweiligen Zustandsgröße des Akkumulators ausgewählt wird, mittels derer unter Verwendung der Meßwerte die jeweilige Zustandsgröße optional berechnet werden kann. Die aktuell ermittelte Zustandsgröße kann die vorherige ersetzen oder mit ihr verrechnet werden, um eine neue Zustandsgröße zu erhalten. Dabei kann zwischen einzelnen Betriebsphasen des elektrischen Systems in zufälliger Weise gewechselt werden. Es kann auch vorgesehen sein, die aktuelle Betriebsphase aus den Meßwerten zu ermitteln und so automatisch die für diese Betriebsphase entsprechende Rechenvorschrift automatisch auszuwählen. Eine Zustandsgröße kann auch mehrmals während des Andauerns einer Betriebsphase ermittelt werden. Auch kann die Ermittlung einer Zustandsgröße über zumindest zwei Betriebsphasen erfolgen. Vorteilhaft läßt sich dieses Verfahren auf unterschiedliche Akkumulatortypen, wie Blei-Säure-Akkumulator und dergleichen, anwenden.

Es wird ferner vorgeschlagen, daß zumindest die zuletzt ermittelten Zustandsgrößen in einer Speichereinheit gespeichert werden. Die aktuellen Zustandsgrößen stehen permanent abrufbereit zur Verfügung, um beispielsweise im Rahmen einer weiteren Verarbeitung zusätzliche Informationen wie Kaltstartfähigkeit, Kapazitätsverlust gegenüber einem neuwertigen Akkumulator und dergleichen zu erhalten. Dazu wird weiter vorgeschlagen, daß für die Aktualisierung und/oder die Ermittlung der Zustandsgrößen die in einer Speichereinheit gespeicherten Daten des neuwertigen Akkumulators bereitgestellt werden.

Darüber hinaus wird vorgeschlagen, daß die Messung zeitlich unbegrenzt und/oder zeitdiskret erfolgt. Die Zustandsgrößen können hierdurch vorteilhaft kontinuierlich nachgehalten werden. Dabei kann die Menge der Meßwerte, insbesondere der zu speichernden Meßwerte, reduziert werden, indem zeitdiskret gemessen wird. Darüber hinaus können die Meßwerte wertediskret erfaßt werden, so daß sie einer digitalen Verarbeitung zugänglich sind.

Es wird ferner vorgeschlagen, daß die Messung des Akkumulatorstroms und der Akkumulatorspannung zeitgleich erfolgen. So kann beispielsweise aus den gleichzeitig gemessenen Werten eine Zustandsgröße ermittelt werden und eine Änderung dieser Zustandsgröße verfolgt werden.

Weiterhin wird vorgeschlagen, daß unterschiedliche Zustandsgrößen in unterschiedlichen Zeiträumen ermittelt werden. So kann beispielsweise eine aktuell ermittelte Zustandsgröße gleichzeitig für die aktuelle Ermittlung einer anderen Zustandsgröße berücksichtigt werden. Zudem kann die Bereitstellung einer aktuell ermittelten Zustandsgröße zeitlich unabhängig von der Bereitstellung einer weiteren Zustandsgröße sein. Eine günstige Auslastung einer Vorrichtung zur Ermittlung der Zustandsgrößen kann erreicht werden.

Darüber hinaus wird vorgeschlagen, daß der Zeitraum zur Ermittlung einer Zustandsgröße vom Auftreten der für deren Bestimmung erforderlichen Betriebsphasenänderung abhängt. Beispielsweise kann der Zeitraum für die Ermittlung einer Zustandsgröße mit der Zeitdauer der Betriebsphase übereinstimmen. Hierdurch können vorteilhaft in den Meßwerten enthaltene, dynamische Zustände ermittelt und/oder bei der Ermittlung der Zustandsgrößen berücksichtigt werden.

Mit Vorteil wird vorgeschlagen, daß das Verfahren beim elektrischen System eines Kraftfahrzeugs angewendet wird. Ein Umklemmen, ein Ab- oder Umschalten des Akkumulators zum Ermitteln der Zustandsgrößen sowie die Erzeugung bestimmter Betriebsbedingungen zum Ermitteln der Zustandsgrößen, beispielsweise im Rahmen eines Testmodus, können vermieden werden. Weiterhin kann zum Beispiel einem Benutzer des Kraftfahrzeugs durch ein integriertes Infomodul angezeigt werden, daß ein Austausch des Akkumulators erforderlich ist, oder daß der Akkumulator mit einer ermittelten Spannung geladen werden soll und dergleichen.

Zweckmäßig wird vorgeschlagen, daß die Messungen während zumindest einer der folgenden Betriebsphasen des Kraftfahrzeugs durchgeführt werden: Ruhe, Vorlauf, Startvorbereitung, Start, Fahrt und Nachlauf. Vorteilhaft können ohnehin verwendete Betriebsphasen des Kraftfahrzeugs verwendet werden, um abhängig von diesen die Rechenvorschrift für die jeweilige Zustandsgröße auszuwählen.

Darüber hinaus wird vorgeschlagen, daß die ermittelten Zustandsgrößen und/oder Meßwerte bei Bedarf angezeigt werden. So kann ein Benutzer beispielsweise einer Anlage mit unterbrechungsfreier Stromversorgung vorteilhaft über die Zeit informiert werden, die während eines Ausfalls einer Energieversorgung überbrückt werden kann, oder ein Benutzer eines Kraftfahrzeugs über den Ladezustand des Akkumulators, oder dessen prognostizierter Lebenserwartung und dergleichen.

Mit der Erfindung wird ferner eine Vorrichtung zur Ermittlung von Zustandsgrößen gemäß dem oben beschriebenen Verfahren vorgeschlagen, wobei die Vorrichtung zumindest an einem Akkumulatorpol eine den gesamten elektrischen Strom durch den Akkumulator erfassende Strommeßeinrichtung, eine die Akkumulatorspannung erfassende Spannungsmeßeinrichtung und eine die Akkumulatortemperatur erfassende Temperaturmeßeinrichtung aufweist. Vorteilhaft stellt die Vorrichtung die erfaßten Meßwerte für eine weitere Verarbeitung bereit und ermittelt die Zustandsgrößen.

Ferner wird vorgeschlagen, daß die Vorrichtung eine Speichereinheit aufweist, in der zumindest die zuletzt ermittelten Zustandsgrößen und die eines neuwertigen Akkumulators speicherbar sind. So können die für die Ermittlung der jeweiligen Zustandsgröße erforderlichen Daten durch Abrufen aus der Speichereinheit bereitgestellt werden. Darüber hinaus können Meßwerte und/oder Zustandsgrößen hinsichtlich ihrer Veränderung überwacht und entsprechende Meldungen erzeugt werden.

Zur Erzeugung der Meldungen und der Ermittlung der Zustandsgrößen wird vorgeschlagen, daß die Vorrichtung eine Auswerteeinheit aufweist. Vorteilhaft kann die Auswerteeinheit durch einen Mikroprozessor gebildet sein, mit dem die gewünschten Berechnungen bei kompakten Aufbau durchgeführt werden können.

Ferner wird vorgeschlagen, daß eine Anzeige- und/oder Signaleinheit vorgesehen ist, mittels derer Meldungen, Meßwerte, Zustandsgrößen oder weitere ermittelte Informationen einem Benutzer angezeigt werden können. Die Anzeige kann optisch, in Form von Anzeigelampen, einer alphanumerischen Anzeige oder dergleichen oder auch akustisch mittels Summer und dergleichen erfolgen. Unterschiedliche Summersignale können beispielsweise unterschiedliche Bedeutungen aufweisen. Auch kann die Anzeige- und/oder Signaleinheit an einer entfernten Stelle, beispielsweise einer Zentrale, angeordnet sein, wobei die Zustandsgrößen und Meßwerte über eine Funk- oder Infrarotverbindung übertragbar sind.

Weiterhin wird vorgeschlagen, daß die zuletzt ermittelten Zustandsgrößen anzeigbar sind. So kann dem Benutzer ein aktueller Zustand des Akkumulators und/oder ein Erreichen von Grenzzuständen vermittelt werden.

Mit Vorteil wird vorgeschlagen, daß bei Erreichung eines kritischen Zustands des Akkumulators eine Warnmeldung ausgebbar ist. Ein Benutzer kann durch rechtzeitige Warnung, einen Ausfall des elektrischen Systems durch geeignete Gegenmaßnahmen, wie Laden oder Austauschen des Akkumulators, vermeiden.

Mit der Erfindung wird ferner ein Akkumulator zur Verwendung mit einer oben genannten erfindungsgemäßen Vorrichtung und mit zumindest einer Energie speichernden Zelle und mit zwei Polen zum Anschluß an ein elektrisches System vorgeschlagen, wobei ein Gehäuse des Akkumulators einen Temperaturmeßsensor aufweist. Der Temperaturmeßsensor kann auf diese Weise die Akkumulatortemperatur genau erfassen, wobei eine Beeinflussung durch Störeinflüsse, wie beispielsweise durch von einem Motor eines Kraftfahrzeugs erzeugte Wärme, weitgehend vermieden werden kann.

Weiterhin wird vorgeschlagen, daß zwei weitere Anschlüsse für eine Spannungsmessung vorgesehen sind. Vorteilhaft sind diese Anschlüsse direkt mit den entsprechenden Elektrodenplatten des Akkumulators verbunden, so daß zum Beispiel die Beeinflussung der Spannungsmessung durch Übergangswiderstände an den Polen, Kontakten und dergleichen, insbesondere bei Stromfluß, vermieden werden kann.

Zudem wird vorgeschlagen, daß eine Strommeßeinrichtung vorgesehen ist. Sie ist möglichst nahe am Akkumulator unterzubringen und nicht nach einem Verteiler.

Die Strommessung kann auch nach einem Verteiler erfolgen, wenn jeder Abgang eine Strommeßeinrichtung aufweist und einer Meßwert-Auswerteeinheit zugeführt wird. Die Strommeßeinrichtung kann vorteilhaft im Gehäuse des Akkumulators vorgesehen sein, wodurch diese gegen mechanische Beanspruchungen geschützt werden kann.

Vorteilhaft kann die Strommeßeinrichtung im oder am Gehäuse des Akkumulators vorgesehen sein, wodurch diese gegen mechanische Beanspruchung geschützt werden kann.

Darüber hinaus wird vorgeschlagen, daß der Akkumulator und die Vorrichtung miteinander verbunden beziehungsweise einstückig ausgebildet sind. Die hierdurch entstandene Baueinheit kann beispielsweise eine Schnittstelle aufweisen, über die die Meßwerte an eine Anzeige- und/oder Signaleinheit ausgebbar sind. Weiterhin wird vorgeschlagen, daß durch die Vorrichtung ermittelte Zustandsgrößen des Akkumulators bereitstellbar sind. So kann vorteilhaft eine kompakte Baueinheit gebildet werden. Der Zustand eines gelagerten Akkumulators kann beispielsweise durch Anschließen an eine Anzeigeeinheit vor einer Verwendung geprüft werden.

Es wird vorgeschlagen, daß aus der Ruhespannung $U_0$ der Ladezustand ermittelt wird. Daneben kann der Ladezustand jedoch auch durch Entladung mit einem mittleren Strom oder durch Bilanzieren einer Ladungsaufnahme und einer Ladungsabgabe ermittelt werden, indem ein Ladungssaldo kontinuierlich mitgeführt wird. Beispielsweise können diese Verfahren auch miteinander kombiniert werden, um Plausibilitätsprüfungen durchführen zu können.

Ferner wird vorgeschlagen, daß der Alterungszustand durch eine Hochstromentladung ermittelt wird. Eine Hochstromentladung kann beispielsweise mit einem Entladestrom des Akkumulators von ungefähr dem halben Kälteprüfstrom nach DIN 43 539 durchgeführt werden. Eine solche Hochstromentladung kann bei einem Kraftfahrzeug auch durch den Startvorgang ausgeführt sein, wobei der Alterungszustand durch die Auswertung der während des Startvorgangs ermittelten Meßwerte bestimmt wird.

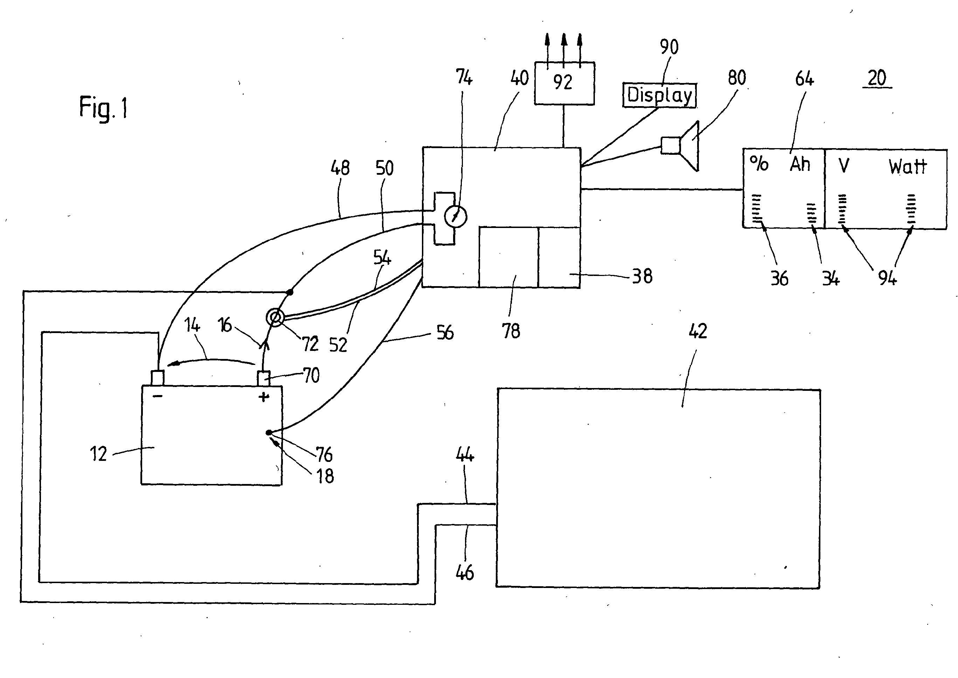

Weitere Vorteile und Merkmale sind der folgenden Beschreibung von Ausführungsbeispielen zu entnehmen. Im wesentlichen gleichbleibende Bauteile sind mit den gleichen Bezugszeichen bezeichnet. Femer wird bezüglich gleicher Merkmale und Funktionen auf die Beschreibung zum Ausführungsbeispiel in Fig. 1 verwiesen.

Es zeigen:

Fig. 1     ein Schaltschema für ein elektrisches System zur Anwendung des erfindungsgemäßen Verfahrens bei einem Kraftfahrzeug,

Fig. 2     ein Ablaufschema für das erfindungsgemäße Verfahren in einem elektrischen System nach Fig. 1,

Fig. 3     ein Schema der Betriebsphasen des Kraftfahrzeugs und

Fig. 4     einen Akkumulator mit einer erfindungsgemäßen Vorrichtung.

Fig. 1 zeigt ein Schaltschema eines elektrischen Systems 20 mit einer elektrischen Anlage 42 eines nicht näher dargestellten Kraftfahrzeugs, die über Leitungen 44, 46 mit einem Akkumulator 12 verbunden ist. Über Leitungen 48, 50, 52, 54, 56 werden von einer Vorrichtung 40 die Akkumulatorspannung 14, der Akkumulatorstrom 16 und die Akkumulatortemperatur 18 gemessen.

Die Vorrichtung 40 weist an einem Akkumulatorpol 70 eine den gesamten elektrischen Strom 16 durch den Akkumulator 12 erfassende Strommeßeinrichtung 72, eine die Akkumulatorspannung 14 erfassende Spannungsmeßeinrichtung 74 und eine die Akkumulatortemperatur 18 erfassende Temperaturmeßeinrichtung 76 auf.

Ferner umfaßt die Vorrichtung 40 eine Speichereinheit 38, in der zumindest die zuletzt ermittelten Zustandsgrößen 34, 36 und die Kennwerte eines neuwertigen Akkumulators 12 speicherbar sind. Darüber hinaus ist eine Auswerteeinheit 78 zur Ermittlung der Zustandsgrößen 34, 36 und weiterer Zustandsgrößen 94 wie zum Beispiel entnehmbare Kapazität, aufnehmbare Ladung oder Grenztemperaturen usw. vorgesehen. Über eine Anzeige- und/oder Signaleinheit 64 sind der aktuelle Alterungszustand 36 und der aktuelle Ladezustand 34 sowie die weiteren Zustandsgrößen 94 anzeigbar. Bei Erreichen eines kritischen Zustands des Akkumulators 12 ist eine Warnmeldung über einen Summer 80 oder ein Display 90 ausgebbar.

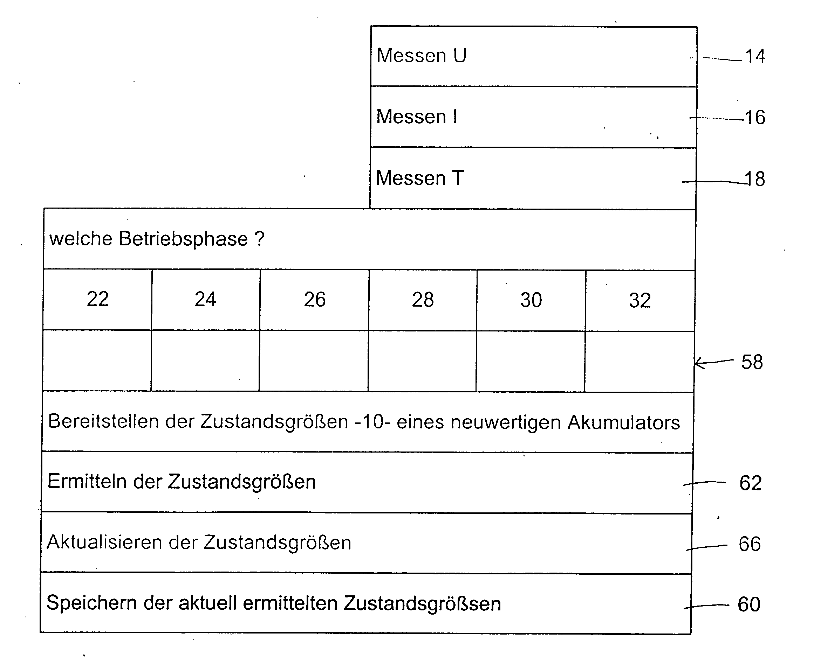

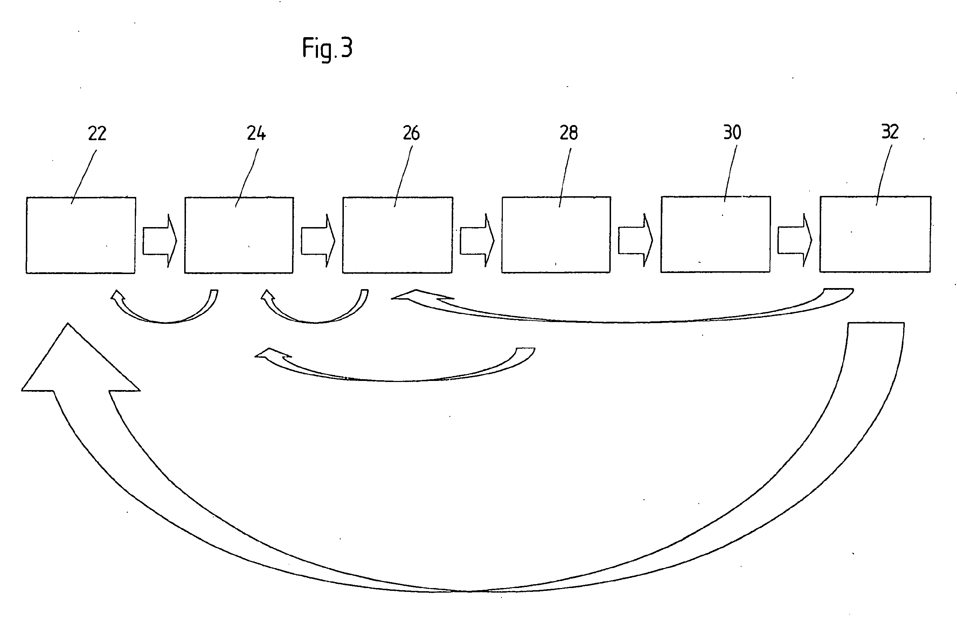

Fig. 2 zeigt ein vereinfachtes Ablaufschema für das erfindungsgemäße Verfahren zur Ermittlung des Ladezustands 34, des Alterungszustands 36 sowie der weiteren Zustandsgrößen 94 des Akkumulators 12, wobei die Akkumulatorspannung 14, der Akkumulatorstrom 16 und die Akkumulatortemperatur 18 während eines bestimmungsgemäßen Betriebs des Akkumulators 12 an einem mit dem Akkumulator 12 elektrisch verbundenen elektrischen System 20 gemessen werden, und wobei durch das elektrische System 20 eine von mehreren wechselbaren Betriebsphasen 22, 24, 26, 28, 30, 32 eingenommen wird (Fig. 3), und eine Rechenvorschrift 58 zur Berechnung der jeweils aus den Meßwerten zu ermittelnden Zustandsgröße 34, 36, 94 in Abhängigkeit der aktuellen Betriebsphase 22, 24, 26, 28, 30, 32 ausgewählt, die jeweilige Zustandsgröße 34, 36, 94 berechnet und die in einer vorherigen Betriebsphase 22, 24, 26, 28, 30, 32 entsprechend ermittelte Zustandsgröße 34, 36, 94 aktualisiert wird.

Die zuletzt ermittelten Zustandsgrößen 34, 36, 94 werden in einer Speichereinheit 38 gespeichert. Für die Aktualisierung und/oder die Ermittlung der Zustandsgrößen 34, 36, 94 werden ferner die in der Speichereinheit 38 gespeicherten Daten des neuwertigen Akkumulators 12 bereitgestellt.

Die Messung der Akkumulatorspannung 14 und des Akkumulatorstroms 16 erfolgt zeitgleich und unter Berücksichtigung der Akkumulatortemperatur 18 unbegrenzt sowie zeit- und wertediskret, um die Meßwerte digital verarbeiten zu können.

Der Ladezustand 34, der Alterungszustand 36 sowie die weiteren Zustandsgrößen 94 werden in unterschiedlichen Zeiträumen ermittelt. Dabei hängt der Zeitraum zur Ermittlung einer Zustandsgröße 34, 36, 94 vom Auftreten der für deren Bestimmung erforderlichen Betriebsphasenänderung ab. So wird beispielsweise der Alterungszustand 36 nur während der Startphase 28 oder einer Hochstromphase ermittelt, wobei die Meßwerte der gesamten Startphase zur Berechnung berücksichtigt werden. Die aktuellen Zustandsgrößen 34, 36, 94 werden gespeichert 60.

Fig. 3 zeigt die Betriebsphasen des Kraftfahrzeugs, während derer die Messungen durchgeführt werden: Ruhe 22, Vorlauf 24, Startvorbereitung 26, Start 28, Fahrt 30 und Nachlauf 32. Die ermittelten Zustandsgrößen 34, 36, 94 werden über die Anzeigeeinheit 64 angezeigt. Darüber hinaus sind die möglichen Übergänge von einer Betriebsphase zu einer anderen durch Pfeile dargestellt.

Die Bestimmung der Betriebsphasen kann bevorzugt auch automatisch erfolgen, indem Signale eines Kraftfahrzuegs ausgewertet werden oder wenn beispielsweise in der Startphase 28 ein vorgegebener Schwellwert des Akkumulatorstroms 16 überschritten ist. Die Ruhephase 22 kann eintreten, wenn ein vorgegebener Schwellwert des Akkumulatorstroms 16 unterschritten wird.

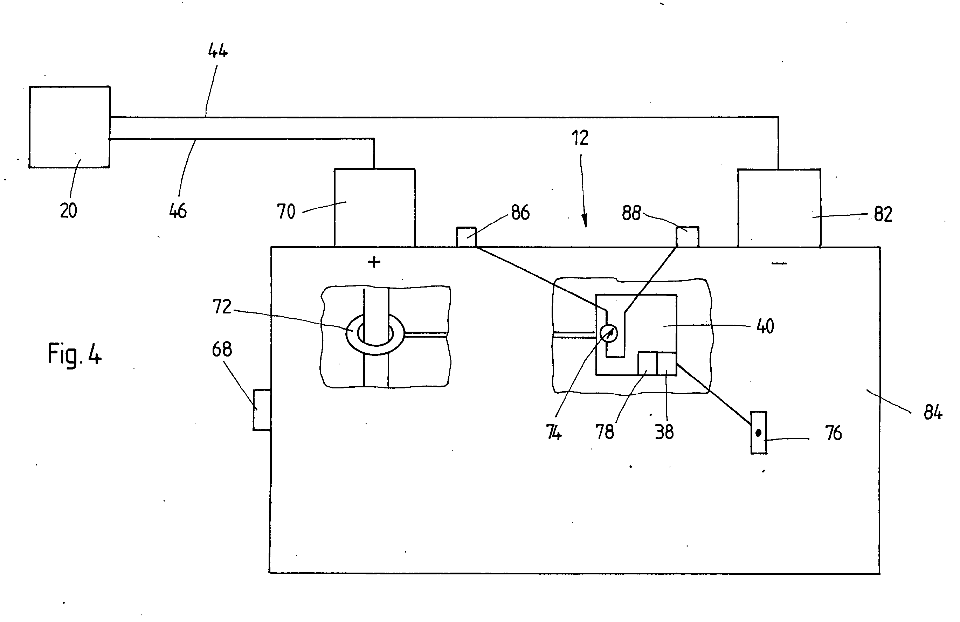

Fig. 4 zeigt einen Akkumulator 12 zur Verwendung mit einer Vorrichtung 40 mit einer Energie speichernden Zelle und mit zwei Polen 70, 82 zum Anschluß an ein elektrisches System 20 über die Leitungen 44, 46, wobei ein Gehäuse 84 des Akkumulators 12 einen Temperaturmeßsensor 76 aufweist.

Ferner sind zwei weitere Anschlüsse 86, 88 für eine Spannungsmessung 14 sowie eine Strommeßeinrichtung 72 vorgesehen. Die Anschlüsse 86, 88 sind nicht an die Pole 70, 82 des Akkumulators 12 sondern direkt an die entsprechenden, nicht näher dargestellten Akkumulatorplatten angeschlossen. Der Akkumulator 12 und die Vorrichtung 40 sind einstückig ausgebildet. Über eine Schnittstelle 68 können die Zustandsgrößen 34, 36, 94 sowie auch weitere Werte bereitgestellt werden. Die Kommunikationsverbindung über die Schnittstelle 68 kann auch durch eine Funkverbindung hergestellt sein.

Die Aufnahme der Daten zur Ermittlung des Alterungszustands erfolgt nur in der Betriebsphase 28 sowie bei Hochstromentladungen. Mit dem Wechsel von der Betriebsphase 26 zur Betriebsphase 28 setzt die Bestimmung ein, indem die zugehörige Rechenvorschrift 58 ausgewählt wird. Die Ermittlung beruht auf der Kenntnis, daß die Akkumulatorspannung 14 bei Belastung des Akkumulators 12 mit einem großen Akkumulatorstrom 16 mit zunehmenden Alter des Akkumulators 12 abnimmt. Zuerst werden die für den Start relevanten Daten bestimmt. Es werden nur Meßwerte berücksichtigt, bei denen der Akkumulatorstrom 16 größer als 20 % des Kälteprüfstroms nach DIN ist. Weiterhin wird die effektive Ruhespannung $U_0$ bestimmt, die vom Ladezustand 34, von der Polarisation und der Akkumulatortemperatur 18 abhängig ist.

Mit der so ermittelten Ruhespannung $U_0$ wird mit den gemessenen Strom- und Spannungsgrößen eine Hilfsgröße "Innenwiderstand" $R_x$ berechnet.

$$R_i = (U_0 - U_i) / I_i$$

$$i = \text{Index des Meßwerts}$$

Durch lineare Regression über die ermittelten $R_i$ wird die Widerstandskurve durch eine Gerade angenähert. Hieraus kann der "Innenwiderstand" $R_x$ beim Kälteprüfstrom $I_k$ ermittelt werden. Daraus wird die äquivalente Startspannung berechnet $U_{eq}$ berechnet mit

$$U_{eq} = U_0 - R_k * I_k$$

k = Kälteprüfparameter

Diese Spannung wird mit der eines neuwertigen Akkumulators 12 verglichen, woraus über ein bekanntes Kennlinienfeld der Alterungszustand ermittelt wird. Zusätzliche Test und Prüfschritte, beispielsweise auf Plausibilität des Ergebnisses können durchgeführt werden. Bei einer großen Abweichung zum vorherigen Wert, die auf eine sehr kurze Restlebensdauer schließen läßt, wird ein Warnsignal über den Summer 80 oder das Display 90 ausgegeben.

Zur Bestimmung des Ladezustands 34 in der Ruhephase 22 wird beispielsweise eine ausreichende Nähe zum Gleichgewichtszustand des Akkumulators 12 angegeben, so daß aus der gemessenen Akkumulatorspannung 14 unter Berücksichtigung des Ruhestromes der Ladezustand berechnet werden. Nach Lade- oder Entladephasen, wie beispielsweise bei einem Übergang vom Fahrbetrieb 30 zum Nachlauf 32, entspricht die Akkumulatorspannung 14 noch nicht der Gleichgewichtsspannung, weil Konzentrationsgradienten und Ladepolarisationseffekte auftreten, die die Akkumulatorspannung 14 anheben oder absenken. Diese werden durch die Größen $\Delta c$ (oder daraus abgeleitet $\Delta U_c$) sowie $\Delta U_p$ berücksichtigt. Diese Korrekturgrößen werden ständig gemäß vorgegebener Differentialgleichungen mitgeführt. Hierdurch kann auch außerhalb des Gleichgewichtszustands die Spannung $U_0$ berechnet werden, und zwar nach

$$U_0 = U - \Delta U_c - \Delta U_p .$$

$\Delta U_c$ = Konzentrationspolatiasation

$\Delta U_p$ = Ladepolarisation

Darüber hinaus kann der Ladezustand 34 bei einer Beaufschlagung des Akkumulator 12 mit einem konstanten Strom 16 ermittelt werden, indem die Akkumulatorspannung 14 nach dem Abbau der Ladepolarisation und nach dem Einstellen eines stationären Konzentrationsgefälles einer Lade- oder Entladekennlinie folgt, die analytisch darstellbar ist und sich für die jeweilige Ausgangssituation (T, I, Anfangsladezustand) auswerten läßt. Die Korrekturgrößen $\Delta U_p$ usw. dienen hier nur als Abschätzung der Gleichgewichtsnähe. Bei signifikanter Abweichung können diese auch zur Korrektur herangezogen werden.

Es wird weiter vorgeschlagen, neben den erwähnten Verfahren zur Bestimmung des Ladezustands 34 kontinuierlich die eingeladene und entnommene Ladung aufzunehmen und so den Ladezustand 34 kontinuierlich zu bestimmen. In den Ladephasen wird hierbei der Ladewirkungsgrad in Abhängigkeit von der Akkumulatortemperatur 18, der Akkumulatorspannung 14, dem Ladezustand 34 und dem Alterungszustand 36 berücksichtigt.

In diesem Ausführungsbeispiel werden die Akkumulatorspannung 14 und der Akkumulatorstrom 16 zeitgleich gemessen. Für die Fachmann ist jedoch klar, daß eine Messung dieser Größen nicht zeitlich miteinander verbunden sein muß. So kann eine Messung beispielsweise auch zeitlich versetzt oder auch unabhängig voneinander erfolgen.

Die in den Figuren dargestellten Ausführungsbeispiele dienen lediglich der Erläuterung der Erfindung und sind für diese nicht beschränkend. So können insbesondere Verfahrensschritte, Rechenvorschriften und Betriebsphasen des Verfahrens, sowie auch Funktionen und Bauteile der Vorrichtung und des Akkumulators usw. variieren.

### Bezugszeichenliste

| 10 | Zustandsgröße |
|----|---------------|
| 12 | Akkumulator |
| 14 | Akkumulatorspannung |
| 16 | Akkumulatorstrom |
| 18 | Akkumulatortemperatur |
| 20 | Elektrisches System |
| 22 | Ruhe |
| 24 | Vorlauf |
| 26 | Startvorbereitung |
| 28 | Start |
| 30 | Fahrt |
| 32 | Nachlauf |
| 34 | Ladezustand |
| 36 | Alterungszustand |
| 38 | Speichereinheit |
| 40 | Auswertevorrichtung |
| 42 | Elektrische Anlage eins Kraftfahrzeugs |
| 44 | Leitung |
| 46 | Leitung |
| 48 | Leitung |
| 50 | Leitung |
| 52 | Leitung |
| 54 | Leitung |
| 56 | Leitung |
| 58 | Rechenvorschrift |
| 60 | Speichern |
| 62 | Ermitteln der Zustandsgrößen |
| 64 | Anzeigeeinheit |
| 66 | Aktualisieren der Zustandsgrößen |

| | |
|---|---|
| 68 | Schnittstelle |
| 70 | Akkumulatorpol |
| 72 | Strommeßeinrichtung |
| 74 | Spannungsmeßeinrichtung |
| 76 | Temperaturmeßeinrichtung |
| 78 | Auswerteeinheit |
| 80 | Summer |
| 82 | Akkumulatorpol |
| 84 | Gehäuse |
| 86 | Anschlußklemme |
| 88 | Anschlußklemme |
| 90 | Display |
| 92 | Infomodul |
| 94 | Weitere Zustandsgrößen |

**Patentansprüche**

1. Verfahren zur Ermittlung von Zustandsgrößen (10) eines Akkumulators (12), insbesondere eines Lade- und/oder Alterungszustands, wobei zumindest die Akkumulatorspannung (14), der Akkumulatorstrom (16) und die Akkumulatortemperatur (18) während eines bestimmungsgemäßen Betriebs des Akkumulators (12) an einem mit dem Akkumulator (12) elektrisch verbundenen elektrischen System (20) gemessen werden, und wobei durch das elektrische System (20) eine von mehreren wechselbaren Betriebsphasen (22, 24, 26, 28, 30, 32) eingenommen wird, und eine Rechenvorschrift zur Berechnung der jeweils aus den Meßwerten zu ermittelnden Zustandsgröße (34, 36, 94) in Abhängigkeit der aktuellen Betriebsphase (22, 24, 26, 28, 30, 32) ausgewählt, die jeweilige Zustandsgröße (34, 36, 94) berechnet und die in einer vorherigen Betriebsphase (22, 24, 26, 28, 30, 32) entsprechend ermittelte Zustandsgröße (34, 36, 94) aktualisiert wird.

2. Verfahren nach Anspruch 1, **dadurch gekennzeichnet, daß** zumindest die zuletzt ermittelten Zustandsgrößen (34, 36, 94) in einer Speichereinheit (38) gespeichert werden.

3. Verfahren nach Anspruch 1 oder 2, **dadurch gekennzeichnet, daß** für die Aktualisierung und/oder die Ermittlung der Zustandsgrößen (34, 36, 94) die in einer Speichereinheit (38) gespeicherten Daten des neuwertigen Akkumulators (12) bereitgestellt werden.

4. Verfahren nach einem der vorhergehenden Ansprüche, **dadurch gekennzeichnet, daß** die Messung zeitlich unbegrenzt und/oder zeitdiskret erfolgt.

5. Verfahren nach einem der vorhergehenden Ansprüche, **dadurch gekennzeichnet, daß** die Messung des Akkumulatorstroms (16) und der Akkumulatorspannung (14) zeitgleich erfolgen.

6. Verfahren nach einem der vorhergehenden Ansprüche, **dadurch gekennzeichnet, daß** unterschiedliche Zustandsgrößen (34, 36, 94) in unterschiedlichen Zeiträumen ermittelt werden.

7. Verfahren nach einem der vorhergehenden Ansprüche, **dadurch gekennzeichnet, daß** der Zeitraum zur Ermittlung einer Zustandsgröße (34, 36, 94) vom Auftreten der für deren Bestimmung erforderlichen Betriebsphasenänderung abhängt.

8. Verfahren nach einem der vorhergehenden Ansprüche, **dadurch gekennzeichnet, daß** das Verfahren bei einem elektrischen System (20) eines Kraftfahrzeugs angewendet wird.

9. Verfahren nach Anspruch 8, **dadurch gekennzeichnet, daß** die Messungen während zumindest einer der folgenden Betriebsphasen des Kraftfahrzeugs durchgeführt werden: Ruhe (22), Vorlauf (24), Startvorbereitung (26), Start (28), Fahrt (30) und Nachlauf (32).

10. Verfahren nach einem der vorhergehenden Ansprüche, **dadurch gekennzeichnet, daß** die ermittelten Zustandsgrößen (34, 36, 94) und/oder Meßwerte angezeigt werden.

11. Verfahren nach einem der vorhergehenden Ansprüche, **dadurch gekennzeichnet, daß** aus der Ruhespannung $U_0$ der Ladezustand (34) ermittelt wird.

12. Verfahren nach einem der vorhergehenden Ansprüche, **dadurch gekennzeichnet, daß** durch Entladung mit einem mittleren Strom der Ladezustand (34) ermittelt wird.

13. Verfahren nach einem der vorhergehenden Ansprüche, **dadurch gekennzeichnet, daß** durch Bilanzieren einer Ladungsaufnahme und einer Ladungsabgabe der Ladezustand (34) ermittelt wird.

14. Verfahren nach einem der vorhergehenden Ansprüche, **dadurch gekennzeichnet, daß** durch eine Hochstromentladung der Alterungszustand (36) ermittelt wird.

15. Verfahren nach einem der vorhergehenden Ansprüche, **dadurch gekennzeichnet, daß** durch Startauswertung der Alterungszustand (36) ermittelt wird.

16. Vorrichtung (40) zur Ermittlung von Zustandsgrößen (34, 36, 94) gemäß dem Verfahren nach einem der vorhergehenden Ansprüche, **dadurch gekennzeichnet, daß** diese zumindest an einem Akkumulatorpol (70) eine den gesamten elektrischen Strom (16) durch den Akkumulator (12) erfassende Strommeßeinrichtung (72), eine die Akkumulatorspannung (14) erfassende Spannungsmeßeinrichtung (74) und eine die Akkumulatortemperatur (18) erfassende Temperaturmeßeinrichtung (76) aufweist.

17. Vorrichtung nach Anspruch 16, **gekennzeichnet durch** eine Speichereinheit (38), in der zumindest die zuletzt ermittelten Zustandsgrößen (34, 36, 94) und die eines neuwertigen Akkumulators (12) speicherbar sind.

18. Vorrichtung nach Anspruch 16 oder 17, **gekennzeichnet durch** eine Auswerteeinheit (78).

19. Vorrichtung nach einem der Ansprüche 16 bis 18, **gekennzeichnet durch** eine Anzeige- und/oder Signaleinheit (64 90).

20. Vorrichtung nach Anspruch 19, **dadurch gekennzeichnet, daß** die zuletzt ermittelten Zustandsgrößen (34, 36, 94) anzeigbar sind.

21. Vorrichtung nach Anspruch 19 oder 20, **dadurch gekennzeichnet, daß** bei Erreichung eines kritischen Zustands des Akkumulators (12) eine Warnmeldung und/oder eine Ladespannung beziehungsweise Signale, die von einem übergeordneten Managementsystem (90, 92) verarbeitbar sind, ausgebbar ist.

22. Akkumulator (12) zur Verwendung mit einer Vorrichtung (40) nach einem der Ansprüche 16 bis 21 mit zumindest einer Energie speichernden Zelle und mit zwei Polen (70, 82) zum Anschluß an ein elektrisches System (20), wobei ein Gehäuse (84) des Akkumulators (12) einen Temperaturmeßsensor (76) aufweist.

23. Akkumulator (12) nach Anspruch 22, **dadurch gekennzeichnet, daß** zwei weitere Anschlüsse (86, 88) für eine Spannungsmessung (14) vorgesehen sind.

24. Akkumulator (12) nach Anspruch 22 oder 23, **dadurch gekennzeichnet, daß** eine Strommeßeinrichtung (72) vorgesehen ist.

25. Akkumulator (12) nach einem der Ansprüche 22 bis 24, **dadurch gekennzeichnet, daß** der Akkumulator (12) und die Vorrichtung (40) einstückig ausgebildet sind.

26. Akkumulator (12) nach Anspruch 25, **dadurch gekennzeichnet, daß** durch die Vorrichtung (40) ermittelte Zustandsgrößen (34, 36, 94) des Akkumulators (12) bereitstellbar sind.

Fig.1

EP 1 298 444 A1

EP 1 298 444 A1

| Messen U | | 14 |
| --- | --- | --- |
| Messen I | | 16 |
| Messen T | | 18 |

| welche Betriebsphase ? | | | | | |
| --- | --- | --- | --- | --- | --- |
| 22 | 24 | 26 | 28 | 30 | 32 |
| | | | | | |

58

Bereitstellen der Zustandsgrößen -10- eines neuwertigen Akumulators

| Ermitteln der Zustandsgrößen | 62 |
| --- | --- |
| Aktualisieren der Zustandsgrößen | 66 |
| Speichern der aktuell ermittelten Zustandsgrößsen | 60 |

Fig.3

EP 1 298 444 A1

Fig. 4

**Europäisches Patentamt**

**EUROPÄISCHER RECHERCHENBERICHT**

Nummer der Anmeldung

EP 01 12 3434

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | FR 2 748 115 A (COMPAGNIE EUROPEENNE D'ACCUMULATEURS) 31. Oktober 1997 (1997-10-31) * Seite 4, Zeile 34 – Seite 5, Zeile 33 * * Seite 6, Zeile 30 – Seite 7, Zeile 16; Abbildungen 1,2 * | 1-5, 7-11,13 | G01R31/36 |
| X A | DE 199 52 963 A (AKKUMULATORENFABRIK MOLL) 23. Mai 2001 (2001-05-23) * Spalte 1, Zeile 31 – Spalte 3, Zeile 13 * * Spalte 6, Zeile 27 – Spalte 7, Zeile 22 * | 16-22, 24-26 1-13 | |
| X A | WO 01 51947 A (HONEYWELL INTERNATIONAL) 19. Juli 2001 (2001-07-19) * Seite 2, Zeile 8 – Zeile 19 * * Seite 4, Zeile 11 – Seite 5, Zeile 23; Abbildungen 1,2 * | 16, 18-22, 24-26 1-4,6, 8-11 | |

**RECHERCHIERTE SACHGEBIETE (Int.Cl.7)**

| Kategorie | | Betrifft Anspruch | |
|---|---|---|---|
| D,A | US 5 281 919 A (PALANISAMY) 25. Januar 1994 (1994-01-25) * Spalte 3, Zeile 3 – Spalte 8, Zeile 8 * * Spalte 10, Zeile 42 – Spalte 11, Zeile 59; Abbildungen 1,2 * | 1-4, 6-12,14, 16 | G01R |
| A | US 4 888 716 A (UENO) 19. Dezember 1989 (1989-12-19) * Zusammenfassung; Abbildung 1 * | 1 | |
| A | DE 32 01 758 A (VARTA) 8. September 1983 (1983-09-08) * Zusammenfassung * | 22 | |

Der vorliegende Recherchenbericht wurde für alle Patentansprüche erstellt

| Recherchenort | Abschlußdatum der Recherche | Prüfer |
|---|---|---|
| DEN HAAG | 26. März 2002 | Iwansson, K |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**EP 1 298 444 A1**

## ANHANG ZUM EUROPÄISCHEN RECHERCHENBERICHT
## ÜBER DIE EUROPÄISCHE PATENTANMELDUNG NR.

EP 01 12 3434

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

26-03-2002

| Im Recherchenbericht angeführtes Patentdokument | | | Datum der Veröffentlichung | Mitglied(er) der Patentfamilie | | | Datum der Veröffentlichung |
|---|---|---|---|---|---|---|---|
| FR | 2748115 | A | 31-10-1997 | FR | 2748115 | A1 | 31-10-1997 |
| DE | 19952963 | A | 23-05-2001 | DE | 19952963 | A1 | 23-05-2001 |
| | | | | WO | 0132462 | A1 | 10-05-2001 |
| | | | | EP | 1147028 | A1 | 24-10-2001 |
| WO | 0151947 | A | 19-07-2001 | US | 2001033169 | A1 | 25-10-2001 |
| | | | | AU | 2781801 | A | 24-07-2001 |
| | | | | AU | 2941101 | A | 24-07-2001 |
| | | | | WO | 0151947 | A1 | 19-07-2001 |
| | | | | WO | 0152147 | A1 | 19-07-2001 |
| | | | | US | 2001049646 | A1 | 06-12-2001 |
| US | 5281919 | A | 25-01-1994 | US | 4937528 | A | 26-06-1990 |
| | | | | DE | 68924169 | D1 | 12-10-1995 |
| | | | | DE | 68924169 | T2 | 21-03-1996 |
| | | | | EP | 0438477 | A1 | 31-07-1991 |
| | | | | JP | 2966870 | B2 | 25-10-1999 |
| | | | | JP | 4502963 | T | 28-05-1992 |
| | | | | WO | 9004188 | A1 | 19-04-1990 |
| | | | | US | 4968942 | A | 06-11-1990 |
| US | 4888716 | A | 19-12-1989 | JP | 1923402 | C | 25-04-1995 |
| | | | | JP | 6050340 | B | 29-06-1994 |
| | | | | JP | 62240876 | A | 21-10-1987 |
| | | | | DE | 3712629 | A1 | 15-10-1987 |
| DE | 3201758 | A | 08-09-1983 | DE | 3201758 | A1 | 08-09-1983 |

Für nähere Einzelheiten zu diesem Anhang : siehe Amtsblatt des Europäischen Patentamts, Nr.12/82